# EUROPEAN PATENT APPLICATION

(11) **EP 4 299 649 A1**
(43) Date of publication of application: **03.01.2024**
(21) Application number: 22759331.6
(22) Date of filing: 04.02.2022
(51) Int. Cl.: C08G 73/10, C08K 9/02, C08L 79/08, H05K 1/05

(54) **POLYIMIDE RESIN COMPOSITION AND METAL-BASED SUBSTRATE**

(30) Priority: 25.02.2021 JP 2021028910
(71) Applicant: Mitsubishi Materials Corporation, Tokyo 100-8117 (JP)
(72) Inventor: HARA Shintaro, Saitama-shi, Saitama 330-8508 (JP); ISHIKAWA Fumiaki, Saitama-shi, Saitama 330-8508 (JP); SUSUKI Kyoka, Saitama-shi, Saitama 330-8508 (JP)
(74) Representative: Hoffmann Eitle
(86) International application number: PCT/JP2022/004379
(87) International publication number: WO 2022/181291

(57) **Abstract**

A polyimide resin composition includes a polyimide resin and a filler dispersed in the polyimide resin, in which the polyimide resin has a dicarboxylic acid group or an acid anhydride group of the dicarboxylic acid group at both ends, and the filler includes at least one inorganic compound selected from the group consisting of aluminum oxide, aluminum hydroxide, magnesium oxide, and magnesium hydroxide on a surface thereof.

## Description

### [Technical Field]

The present invention relates to a polyimide resin composition and a metal base substrate.

The present application claims priority on Japanese Patent Application No. 2021-028910 filed on February 25, 2021, the content of which is incorporated herein by reference.

### [Background Art]

Metal base substrates are known as one example of substrates for mounting electronic components such as semiconductor elements and LEDs. A metal base substrate is a laminate in which a metal substrate, an insulating film, and a metal circuit layer are laminated in this order. Electronic components are mounted on the metal circuit layer through solder.

In the metal base substrate having this configuration, the heat generated by the electronic components is transferred to the metal substrate through the insulating film and dissipated from the metal substrate to the outside.

The insulating film of the metal base substrate is generally formed from an insulating composition that includes a resin having excellent insulation and voltage resistance and a filler having excellent thermal conductivity. As resins for insulating films, polyimide resin, polyamide resin, polyamide-imide resin, epoxy resin, silicone resin, and the like are used. In addition, as fillers for insulating films, aluminum oxide particles, aluminum hydroxide particles, magnesium oxide particles, magnesium hydroxide particles, aluminum nitride particles, silica particles, silicon carbide particles, titanium oxide particles, boron nitride particles, and the like are used (Patent Documents 1 to 5).

### [Citation List]

### [Patent Documents]

[Patent Document 1]
   United States Patent Application, Publication No. 2007/0116976 (A)
[Patent Document 2]
   Japanese Unexamined Patent Application, First Publication No. 2013-60575 (A)
[Patent Document 3]
   Japanese Unexamined Patent Application, First Publication No. 2009-13227 (A)
[Patent Document 4]
   Japanese Unexamined Patent Application, First Publication No. 2013-159748(A)
[Patent Document 5]
   Japanese Unexamined Patent Application, First Publication No. 2019-140094 (A)

### [Summary of Invention]

### [Technical Problem]

A metal base substrate is manufactured, for example, by forming an insulating film on a metal substrate and then subjecting the insulating film and a metal circuit layer to thermal compression-bonding. As a method for forming the insulating film on the metal substrate, for example, a method including: a step of coating a resin solution in which a filler is dispersed on the substrate; and a step of drying the obtained coated film may be used. In the case of this method, voids (pores) may be generated between the resin and the filler when the coated film is dried. When voids are generated between the resin and the filler in the insulating film, there is a concern that the thermal conductivity of the insulating film may decrease because the void portions do not easily conduct heat. Furthermore, there is a concern that the voltage resistance of the insulating film may decrease because dielectric breakdown of the insulating film is likely to occur due to partial discharges occurring in the void portions.

The present invention was made in consideration of the above-described circumstances and provides a resin composition including a filler and a resin, which is less likely to generate voids and has excellent thermal conductivity and voltage resistance, and a metal base substrate using this resin composition as an insulating film.

### [Solution to Problem]

In order to solve the problems described above, a resin composition of one aspect of the present invention (referred to below as the "polyimide resin composition of the present invention") includes a resin, and a filler dispersed in the resin, in which the resin includes a polyimide resin having a dicarboxylic acid group or an acid anhydride group of the dicarboxylic acid group at both ends, and the filler includes at least one inorganic compound selected from the group consisting of aluminum oxide, aluminum hydroxide, magnesium oxide, and magnesium hydroxide on a surface thereof.

According to the polyimide resin composition having this configuration, the polyimide resin included in the resin, which is the base material, has a dicarboxylic acid group or an acid anhydride group of the dicarboxylic acid group at both ends and the filler includes an inorganic compound such as aluminum oxide, aluminum hydroxide, magnesium oxide, and magnesium hydroxide on the surface thereof, thus, the resin and the filler have a high affinity for each other and are easily chemically bonded. For this reason, the bonding force between the resin and the filler becomes stronger and voids are less likely to occur between the resin and the filler. Thus, the polyimide resin composition having the configuration described above has an improved thermal conductivity coefficient and withstand voltage.

In the polyimide resin composition of the present invention, the polyimide resin may be a compound represented by General Formula (1) or General Formula (2).

In such a case, since the polyimide resin is a compound represented by General Formula (1) or General Formula (2), the bonding force between the polyimide resin and the filler is even stronger and voids are even less likely to occur between the polyimide resin and the filler.

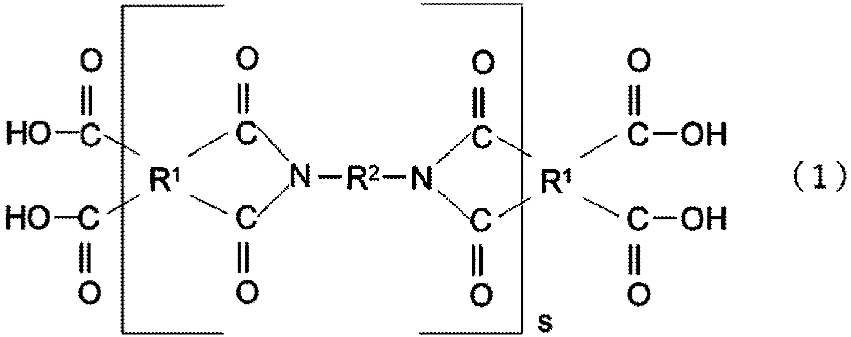

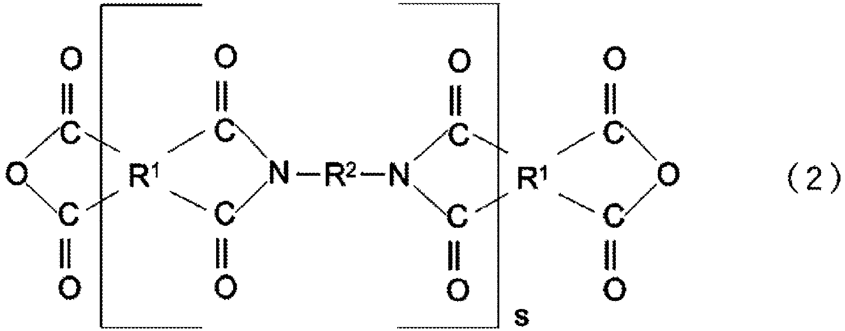

In General Formula (1) and General Formula (2), R1 represents a tetravalent organic group, R2 represents a divalent organic group, and S represents a number in a range of 10 or more and 200 or less calculated from the number average molecular weight.

In addition, in the polyimide resin composition of the present invention, a number average molecular weight of the polyimide resin may be in a range of 5000 or more and 50000 or less.

In such a case, since the number average molecular weight of the polyimide resin is in a range of 5000 or more and 50000 or less, the flowability of the polyimide resin is controlled and defects are less likely to occur during resin-to-metal bonding.

In addition, in the polyimide resin composition of the present invention, an amount of the filler may be in a range of 60% by mass or more and 90% by mass or less.

In such a case, since the amount of the filler is in a range of 60% by mass or more and 90% by mass or less, the thermal conductivity is reliably improved.

In addition, in the polyimide resin composition of the present invention, a ratio of the polyimide resin in the resin may be in a range of 66% by mass or more and 100% by mass or less.

In such a case, since the resin includes a polyimide resin having a dicarboxylic acid group or an acid anhydride group of the dicarboxylic acid group at both ends in an amount as described above, the bonding force between the resin and the filler becomes even stronger.

A metal base substrate of another aspect of the present invention (referred to below as the "metal base substrate of the present invention") is a metal base substrate including a metal substrate, an insulating film, and a metal circuit layer, which are laminated in this order, in which the insulating film consists of the polyimide resin composition described above.

The metal base substrate having this configuration has excellent thermal conductivity and voltage resistance since the insulating film consisting of the polyimide resin composition described above is arranged between the metal substrate and the metal circuit layer.

### [Advantageous Effects of Invention]

According to the present invention, it is possible to provide a resin composition including a filler and a resin, which is less likely to generate voids and has excellent thermal conductivity and voltage resistance, and a metal base substrate using this resin composition as an insulating film.

### [Brief Description of Drawings]

FIG. 1 is a schematic cross-sectional view of a polyimide resin composition, which is an embodiment of the present invention.
FIG. 2 is a schematic cross-sectional view of a metal base substrate according to an embodiment of the present invention.

### [Description of Embodiments]

A description will be given of a polyimide resin composition and a metal base substrate, which are embodiments of the present invention, with reference to the accompanying drawings.

### <Polyimide Resin Composition>

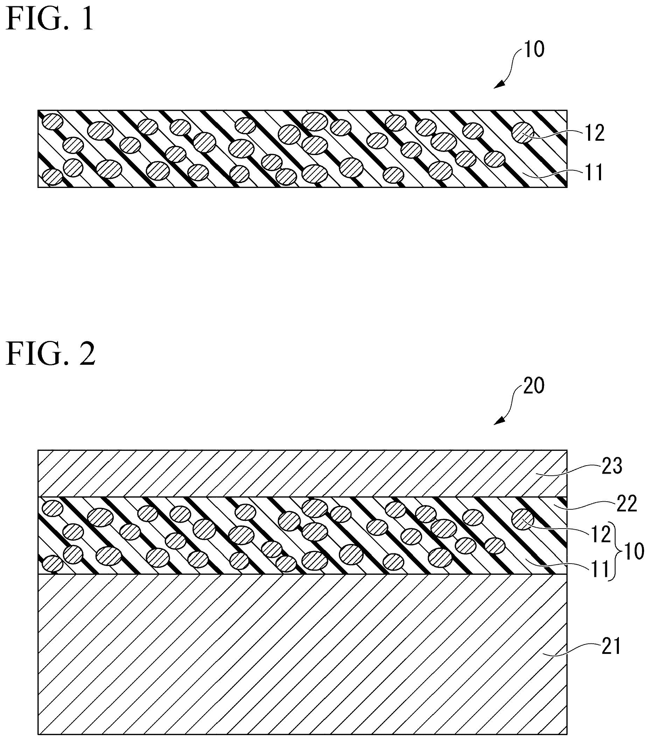

FIG. 1 is a schematic cross-sectional view of a polyimide resin composition which is an embodiment of the present invention.

As shown in FIG. 1, a polyimide resin composition 10 that is the present embodiment includes a polyimide resin 11 and a filler 12 dispersed in the polyimide resin 11. The amount of the filler 12 in the polyimide resin composition 10 on a mass basis is preferably in a range of 60% by mass or more and 90% by mass or less and particularly preferably in a range of 70% by mass or more and 88% by mass or less. Although not particularly limited, the amount of the filler 12 on a mass basis may be 80% by mass or more and 85% by mass or less.

In addition, the amount of the filler 12 in the polyimide resin composition 10 on a volume basis is preferably in a range of 40% by volume or more and 80% by volume or less and particularly preferably in a range of 45% by volume or more and 75% by volume or less. Although not particularly limited, the amount of the filler 12 on a volume basis may be 50% by volume or more and 65% by volume or less.

### (Polyimide Resin 11)

The polyimide resin 11 is the base material (matrix resin) of the polyimide resin composition 10. The polyimide resin 11 has a dicarboxylic acid group or an acid anhydride group of the dicarboxylic acid group at both ends. For this reason, the polyimide resin 11 has a high affinity for inorganic compounds such as aluminum oxide, aluminum hydroxide, magnesium oxide, and magnesium hydroxide and easily chemically bonds with the above-described inorganic compounds.

The polyimide resin 11 may be a compound represented by General Formula (1) or General Formula (2).

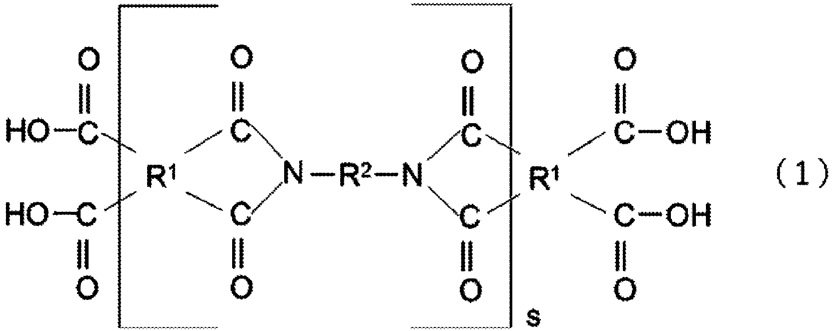

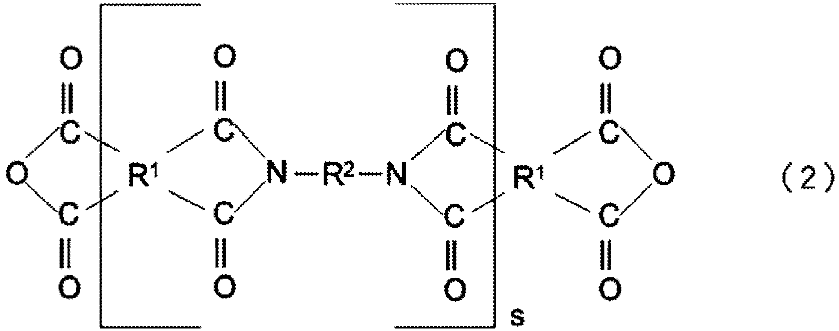

In General Formula (1) and General Formula (2), R1 represents a tetravalent organic group, R2 represents a divalent organic group, and S represents a number of 10 or more and 200 or less calculated from the number average molecular weight.

The tetravalent organic group represented by R1 may be a tetravalent aromatic hydrocarbon group which is obtained by removing four hydrogen atoms from an aromatic hydrocarbon, or a tetravalent alicyclic hydrocarbon group which is obtained by removing four hydrogen atoms from an alicyclic hydrocarbon. Examples of the aromatic hydrocarbon include monocyclic aromatics, condensed polycyclic aromatics, and noncondensed polycyclic aromatics in which two monocyclic aromatics are linked to each other directly or by cross-linking groups. The number of carbon atoms in the alicyclic hydrocarbons may be in a range of 4 or more and 8 or less.

The tetravalent organic group represented by R1 may be, for example, a group represented by any one of General Formulas (3) to (6).

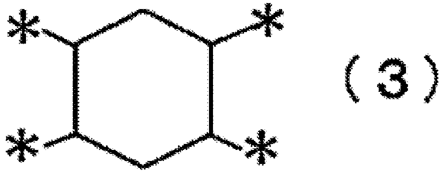

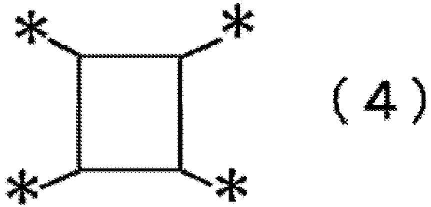

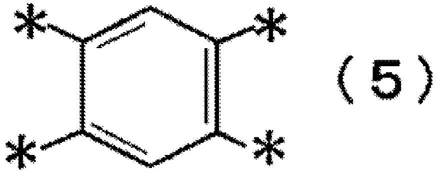

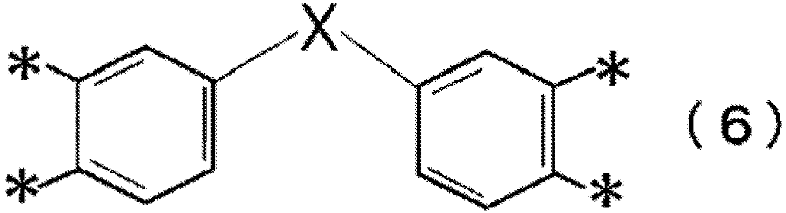

In General Formulas (3) to (6), * represents an atomic bond.

In General Formula (6), X represents a cross-linking group. The cross-linking group may be a divalent hydrocarbon group, an oxygen atom, a sulfur atom, a carbonyl group, a sulfonyl group, an imino group, or a group in which these groups are combined. The divalent hydrocarbon group may be, for example, an aliphatic group (an alkylene group, an alkenylene group, or an alkynylene group) having 1 to 10 carbon atoms, a cycloalkylene group having 4 to 10 carbon atoms, an arylene group, or a group combining the above-described groups. The divalent aliphatic group and the imino group may have substituents. Examples of the substituents include monovalent hydrocarbon groups, carbon fluoride groups in which a monovalent hydrocarbon group is substituted with fluorine, alkoxy groups having 1 to 10 carbon atoms, and -OCOCH₃ group. The monovalent hydrocarbon group may be, for example, an aliphatic group (an alkyl group, an alkenyl group, or an alkynyl group) having 1 to 10 carbon atoms, a cycloalkyl group having 4 to 10 carbon atoms, an aryl group having 6 to 10 carbon atoms, or an aralkyl group having 7 to 10 carbon atoms. The cross-linking group represented by X may be, for example, a group represented by any one of Formulas (7) to (13).

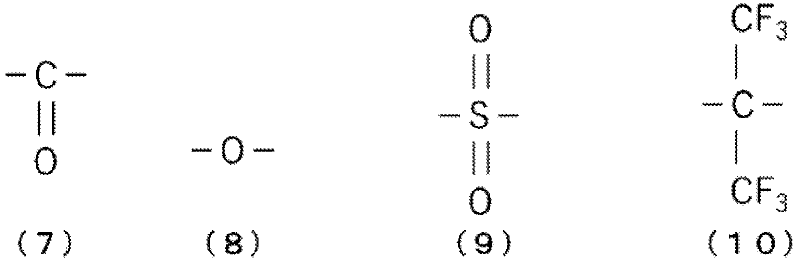

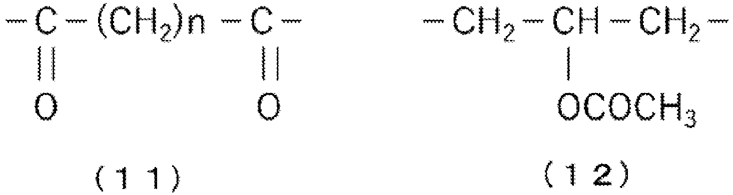

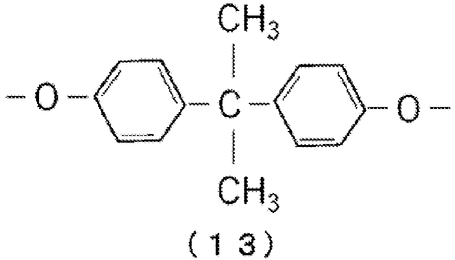

The divalent organic group represented by R2 preferably has a methylene chain. The methylene chain preferably has 3 or more carbon atoms. The divalent organic group may be a group in which a methylene chain and a divalent linking group are combined. The divalent linking group may be a divalent hydrocarbon group, an oxygen atom, a sulfur atom, a carbonyl group, a sulfonyl group, an imino group, an -(Si(R3R4)-O)ₙ- group (R3 and R4 in the formula each independently represent an alkyl group having 1 to 10 carbon atoms and n represents a number in a range of 1 or more and 30 or less), or a group in which these groups are combined. The divalent hydrocarbon group may be, for example, an aliphatic group (an alkylene group, an alkenylene group, or an alkynylene group) having 1 to 10 carbon atoms, a cycloalkylene group having 4 to 10 carbon atoms, an arylene group having 6 to 10 carbon atoms, or a group combining the above-described groups. The divalent hydrocarbon group and the imino group may have substituents. Examples of the substituents include monovalent hydrocarbon groups. The monovalent hydrocarbon group may be, for example, an aliphatic group (an alkyl group, an alkenyl group, or an alkynyl group) having 1 to 10 carbon atoms, a cycloalkyl group having 4 to 20 carbon atoms, an aryl group having 6 to 10 carbon atoms, or an aralkyl group having 7 to 20 carbon atoms.

The divalent organic group represented by R2 may be, for example, a group represented by any one of General Formulas (14) to (15). In addition, the divalent organic group represented by R2 may be, for example, a dimer-diamine-derived hydrocarbon group having a methylene chain. In the dimer-diamine-derived hydrocarbon group, the number of carbon atoms may be in a range of 20 to 50 and the number of hydrogen atoms may be in a range of (m×2-6) or more and (m×2) or less, in which m is the number of carbon atoms.

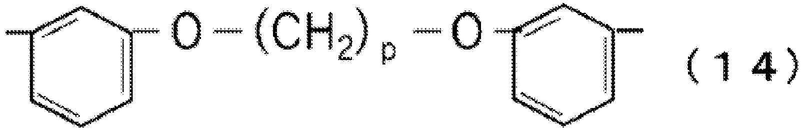

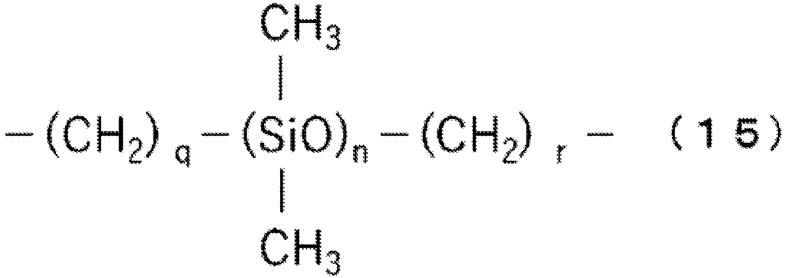

In General Formula (14), p represents a number in a range of 3 or more and 10 or less.

In General Formula (15), q and r each independently represent a number in a range of 3 or more and 8 or less and n represents a number in a range of 1 or more and 30 or less.

It is possible to manufacture the polyimide resin 11, for example, by a method including: a step of reacting tetracarboxylic dianhydride and diamine in an organic solvent to produce polyamide acid; and a step of imidizing the polyamide acid. As the tetracarboxylic dianhydride, the compound represented by General Formula (16) may be used. As the diamine, the compound represented by General Formula (17) may be used.

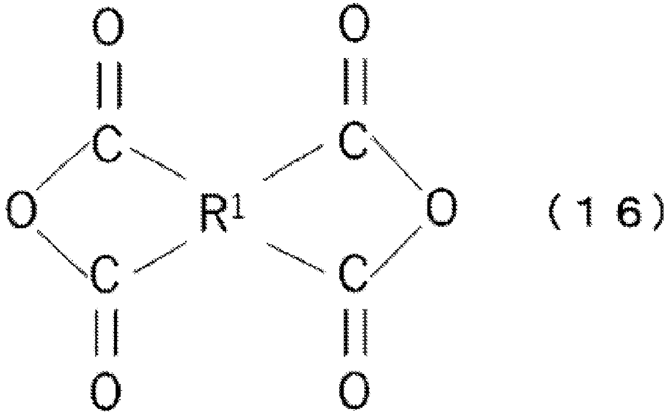

In General Formula (16), R1 is the same as that in General Formula (1) and General Formula (2).

NH₂-R²-NH₂ (17)

In General Formula (17), R2 is the same as that in General Formula (1) and General Formula (2).

Polar organic solvents may be used as the organic solvent. Examples of the polar organic solvent include N,N-dimethylformamide (DMF), N,N-dimethylacetamide (DMAC), N-methyl-2-pyrrolidone (NMP), and cyclohexanone.

In the step of producing a polyamide acid, the polyamide acid may be produced by stirring and mixing an organic solvent, tetracarboxylic dianhydride, and diamine to cause a reaction between the tetracarboxylic dianhydride and diamine. The reaction temperature may be, for example, in a range of 10°C or higher and 100°C or lower. The reaction atmosphere may be an air atmosphere or an inert gas atmosphere (for example, argon or nitrogen).

In the polyimide resin 11, the dicarboxylic acid group or anhydride group thereof present at both ends thereof is derived from the raw material of tetracarboxylic dianhydride. In order to ensure the presence of the dicarboxylic acid group or the anhydride group thereof at both ends of the polyimide resin 11, the amount of tetracarboxylic dianhydride in the organic solvent may be greater than that of diamine. The mixing ratio of tetracarboxylic dianhydride with respect to diamine in the organic solvent (tetracarboxylic dianhydride/diamine ratio) may be in a range of 1.005 or more and 1.2 or less.

In the step of imidizing the polyamide acid, as the method for imidizing the polyamide acid in a polyamide acid solution, it is possible to use a method in which the polyamide acid solution is heated or a method in which an imidization catalyst is added to the polyamide acid solution. In a case of heating the polyamide acid solution, the heating temperature may be in a range of 100°C or higher and 300°C or lower. In a case of adding an imidization catalyst, as the imidization catalyst, it is possible to use amine compounds used as imidization catalysts in the prior art, such as aliphatic amines, alicyclic amines, and aromatic amines.

The number average molecular weight of the polyimide resin 11 is preferably in a range of 5000 or more and 50000 or less and particularly preferably in a range of 8000 or more and 30000 or less. Although not particularly limited, the number average molecular weight of the polyimide resin 11 may be 10000 or more and 15000 or less.

### (Filler 12)

The filler 12 includes, on the surface, at least one inorganic compound selected from the group consisting of aluminum oxide, aluminum hydroxide, magnesium oxide, and magnesium hydroxide. Due to the presence of the inorganic compound on the surface of the filler 12, the bonding force between the polyimide resin 11 and the filler 12 becomes stronger and voids are less likely to occur between the polyimide resin 11 and the filler 12. The filler may be a single particle including only one type of the above-described inorganic compounds or may be a composite particle combining two or more types of the above-described inorganic compounds. In addition, the filler 12 may also be a coated particle in which a part or whole of the surface of the core particle is coated with one type or two or more types of the above-described inorganic compounds. For example, as the core particles, it is possible to use aluminum nitride particles, silica particles, silicon carbide particles, titanium oxide particles, and boron nitride particles. One of these particles may be used alone or a combination of two or more types may be used.

In a case where the filler 12 includes a component different from the inorganic compound and a part of the surface thereof is coated with the inorganic compound, at least 50% or more of the surface of the filler is coated with the inorganic compound.

Regarding the coverage ratio, it is possible to acquire the coverage ratio (area coverage ratio) on the particle surface by fixing 10 or more fillers on a tape or the like and measuring the area of each composition by SEM and EDX.

An average particle diameter of the filler 12 is preferably in a range of 0.1 µm or more and 20 µm or less. The thermal conductivity of the resin composition is improved in a case where the average particle diameter of the filler 12 is 0.1 µm or more. The voltage resistance of the resin composition is improved in a case where the average particle diameter of the filler 12 is 20 µm or less. In addition, in a case where the average particle diameter of the filler 12 is in the range described above, the filler 12 does not easily form aggregated particles and does not easily settle; and therefore, it is possible to uniformly disperse the filler 12 in the polyimide resin 11. In a case where the filler 12 is dispersed in the insulating resin as primary particles or near primary fine particles without forming aggregated particles, the voltage resistance of the polyimide resin 11 is improved. The average particle diameter of the filler 12 is preferably in a range of 0.3 µm or more and 20 µm or less.

### (Method for Manufacturing Polyimide Resin Composition 10)

Next, a description will be given of the method for manufacturing the polyimide resin composition 10 of the present embodiment.

It is possible to manufacture the polyimide resin composition 10, for example, by a method including a preparation step of preparing a filler-dispersed polyimide resin solution and a forming step of coating the filler-dispersed polyimide resin solution and drying the obtained coated film.

In the preparation step, the filler-dispersed polyimide resin solution may be prepared, for example, as follows. First, the polyimide resin 11 is dissolved in an organic solvent to obtain a polyimide resin solution. As the organic solvent, for example, a polar organic solvent used in the manufacturing of the polyimide resin may be used. Next, the polyimide solution and the filler 12 are mixed to obtain a mixture. Then, the mixture is subjected to a dispersion treatment to disperse the filler 12 in a solution of the polyimide resin 11. As the dispersion treatment, it is possible to use an ultrasonic dispersion treatment, a dispersion treatment using a ball mill, or a treatment in which particles are dispersed by colliding raw materials which are ejected at a high pressure.

In the forming step, as a method for coating the filler-dispersed polyimide resin solution, it is possible to use a spin-coating method, a bar-coating method, a knife-coating method, a roll-coating method, a blade-coating method, a die-coating method, a gravure-coating method, a dip-coating method, or the like. As the method for drying the coated film, it is possible to use a method such as heat drying, hot air drying, or reduced-pressure drying. The drying temperature is preferably 100°C or higher and the thermal decomposition temperature of the polyimide resin or lower. By heating at a temperature of 100°C or higher, the bonding force between the polyimide resin and the filler becomes stronger.

According to the polyimide resin composition 10 of the present embodiment formed as described above, the polyimide resin 11, which is the base material, has a dicarboxylic acid group or an acid anhydride group of the dicarboxylic acid group at both ends, and the filler 12 includes, on the surface, an inorganic compound such as aluminum oxide, aluminum hydroxide, magnesium oxide, and magnesium hydroxide, thus, the polyimide resin 11 and the filler 12 have a high affinity for each other and are easily chemically bonded. For this reason, the bonding force between the polyimide resin 11 and the filler 12 becomes stronger and voids are less likely to occur between the polyimide resin 11 and the filler 12. Therefore, the polyimide resin composition 10 of the present embodiment improves the thermal conductivity and withstand voltage.

In the polyimide resin composition 10 of the present embodiment, in a case where the polyimide resin 11 is a compound represented by General Formula (1) or General Formula (2), the bonding force between the polyimide resin 11 and the filler 12 is stronger and voids are even less likely to occur between the polyimide resin 11 and the filler 12. In addition, in the polyimide resin composition 10 of the present embodiment, in a case where the number average molecular weight of the polyimide resin 11 is in a range of 5000 or more and 50000 or less, the hardness and flexibility of the polyimide resin 11 are well balanced and deformation does not easily occur, thus, the thermal conductivity and withstand voltage of the polyimide resin composition 10 are stable over a long period of time. Furthermore, in a case where the amount of the filler 12 in the polyimide resin composition 10 of the present embodiment is in a range of 60% by mass or more and 90% by mass or less, the thermal conductivity is reliably improved.

### <Metal Base Substrate 20>

FIG. 2 is a schematic cross-sectional view of a metal base substrate which is an embodiment of the present invention.

A metal base substrate 20 is a laminate formed by laminating a metal substrate 21, an insulating film 22, and a metal circuit layer 23 in this order.

The metal substrate 21 is a member forming the base of the metal base substrate 20. As the metal substrate 21, it is possible to use copper sheets, aluminum sheets, and laminated sheets thereof.

The insulating film 22 is a member for insulating the metal substrate 21 and the metal circuit layer 23. The insulating film 22 consists of the polyimide resin composition 10 shown in FIG. 1 and includes the polyimide resin 11 and the filler 12 dispersed in the polyimide resin 11. For this reason, the same reference numerals are used, for which a detailed description is not repeated.

The metal circuit layer 23 is formed in the shape of a circuit pattern. Electronic components are bonded through solder or the like on the metal circuit layer 23 formed in the shape of a circuit pattern. As the material for the metal circuit layer 23, it is possible to use copper, aluminum, gold, and the like.

Examples of the electronic components mounted on the metal circuit layer 23 are not particularly limited but examples thereof include semiconductor elements, resistors, capacitors, crystal oscillators, and the like. Examples of the semiconductor element include metal-oxide-semiconductor field effect transistors (MOSFETs), insulated gate bipolar transistors (IGBTs), large scale integrations (LSI), light emitting diodes (LEDs), LED chips, and LED-Chip Size Packages (LED-CSPs).

Next, a description will be given of the method for manufacturing the metal base substrate 20 of the present embodiment.

It is possible to manufacture the metal base substrate 20 of the present embodiment, for example, by a method including: an insulating film forming step of forming the insulating film 22 on one surface of the metal substrate 21; and a metal circuit layer compression-bonding step of compression-bonding the metal circuit layer 23 on the insulating film 22.

In the insulating film forming step, it is possible to form the insulating film 22, for example, by a method including: coating a filler-dispersed polyimide resin solution on one surface of the metal substrate 21; and then drying the obtained coated film. The method for preparing the filler-dispersed polyimide resin solution, the method for coating the filler-dispersed polyimide resin solution, and the method for drying the coated film are the same as those in the method for manufacturing the polyimide resin composition 10 described above.

In the metal circuit layer compression-bonding step, it is possible to compression-bond the metal circuit layer 23, for example, by a method including: laminating the metal circuit layer 23 on the insulating film 22; and then pressing the obtained laminate in the lamination direction while heating. The heating temperature is preferably 200°C or higher and particularly preferably 250°C or higher. The upper limit of the heating temperature is less than the thermal decomposition temperature of the polyimide resin 11 and preferably a temperature that is 30°C or more below the thermal decomposition temperature. The pressure during the pressing is preferably in a range of 1 MPa or more and 30 MPa or less and particularly preferably in a range of 3 MPa or more and 25 MPa or less. The compression-bonding time differs according to the heating temperature and pressure, but is generally 10 minutes or more and 180 minutes or less.

According to the metal base substrate 20 which is the present embodiment formed as described above, the insulating film 22 consisting of the polyimide resin composition 10 described above is arranged between the metal substrate 21 and the metal circuit layer 23, and thus the thermal conductivity and voltage resistance are excellent.

Although embodiments of the present invention are described above, the present invention is not limited thereto and is able to be modified as appropriate in a range not departing from the technical features of the invention.

For example, in the present embodiment, an example is described in which the polyimide resin 11 having a dicarboxylic acid group or an acid anhydride group of the dicarboxylic acid group at both ends is used alone as the resin included in the polyimide resin composition 10, but polyimide resin composition 10 may further include other resins. For example, as other resins, it is possible to use polyimide resins having an amine group on at least one end and epoxy resins. However, in the resin included in the polyimide resin composition 10, the amount of the polyimide resin 11 having a dicarboxylic acid group or an acid anhydride group of the dicarboxylic acid group at both ends is preferably in a range of 66% by mass or more and 100% by mass or less.

In addition, in the present embodiment, an example is described in which the polyimide resin composition 10 is used as the insulating layer of the metal base substrate 20, but the applications of the polyimide resin composition 10 are not limited thereto. The polyimide resin composition 10 may, for example, be used as an insulating film for an insulating conductor coated with an insulating film, such as an enameled wire.

### [Examples]

### [Synthesis Example 1: Synthesis of Polyimide Resin A]

6.20 g of PMDD (3,3'-(pentamethylenedioxy)dianiline, manufactured by Merck KGaA) was added to 100 g of DMF (N,N-dimethylformamide, manufactured by Fujifilm Wako Pure Chemical Corporation) and dissolved, then, 10.10 g of 6FDA (4,4'-(hexafluoroisopropylidene)diphthalic anhydride, manufactured by Tokyo Chemical Industry Co., Ltd.) was added thereto. Thereafter, polyamic acid was produced by stirring and mixing the mixture for 72 hours at room temperature in an argon atmosphere. The obtained polyamic acid solution was transferred to an evaporating dish and dried and sintered in a reduced pressure atmosphere at a temperature of 50°C for 24 hours, at a temperature of 200°C for 5 hours, and at a temperature of 250°C for 30 minutes in this order to obtain a polyimide resin A having dicarboxylic anhydride at both ends. The molar ratio of 6FDA/PMDD in the mixed solution was 1.05.

The number average molecular weight of the obtained polyimide resin A was 11000.

### [Synthesis Example 2: Synthesis of Polyimide Resin B]

6.20 g of PMDD was added to 100 g of DMF and dissolved, then 9.14 g of 6FDA was added thereto. Thereafter, polyamic acid was produced by stirring and mixing the mixture for 72 hours at room temperature in an argon atmosphere. The obtained polyamic acid solution was transferred to an evaporating dish and dried and sintered under a reduced pressure atmosphere at a temperature of 50°C for 24 hours, at a temperature of 200°C for 5 hours, and at a temperature of 250°C for 30 minutes in this order to obtain a polyimide resin B having an amine group at both ends. The molar ratio of 6FDA/PMDD in the mixed solution was 0.95.

The number average molecular weight of the obtained polyimide resin B was 11000.

### [Synthesis Example 3: Synthesis of Polyimide Resin C]

6.20 g of V551 (Versamine 551, manufactured by BASF Japan Ltd.) was added to 100 g of cyclohexanone and dissolved, then 4.93 g of ODPA (4,4'-oxydiphthalic anhydride, manufactured by Tokyo Chemical Industry Co., Ltd.) was added thereto. Thereafter, polyamic acid was produced by stirring and mixing the mixture for 72 hours at room temperature in an argon atmosphere. The obtained polyamic acid solution was transferred to an evaporating dish and dried and sintered under a reduced pressure atmosphere at a temperature of 50°C for 24 hours and at a temperature of 150°C for 5 hours to obtain a polyimide resin C having a dicarboxylic anhydride group at both ends. The molar ratio of ODPA/V551 in the mixed solution was 1.05.

The number average molecular weight of the obtained polyimide resin C was 11000.

### [Synthesis Example 4: Synthesis of Polyimide Resin D]

6.20 g of V551 was added to 100 g of cyclohexanone and dissolved, then 4.46 g of ODPA was added thereto. Thereafter, polyamic acid was produced by stirring and mixing the mixture for 72 hours at room temperature in an argon atmosphere. The obtained polyamic acid solution was transferred to an evaporating dish and dried and sintered under a reduced pressure atmosphere at a temperature of 50°C for 24 hours and at a temperature of 150°C for 5 hours to obtain a polyimide resin D having an amine group at both ends. The molar ratio of ODPA/V551 in the mixed solution was 0.95.

The number average molecular weight of the obtained polyimide resin D was 11000.

### [Inventive Example 1]

5 g of the polyimide resin A was added to 10 g of DMF and stirred until the polyimide resin A was uniformly dissolved.

Aluminum oxide powder (average particle diameter: 3 µm) was added to the obtained polyimide resin solution so that the amount of the aluminum oxide powder became 60% by mass in terms of mass (35% by volume in terms of volume) with respect to the total amount of the polyimide resin A and the aluminum oxide powder and the mixture was stirred with a magnetic stirrer. The obtained mixture was subjected to a dispersion treatment by repeating a high-pressure ejection treatment ten times at a pressure of 50 MPa using a Starburst manufactured by Sugino Machine Ltd., to prepare a filler-dispersed polyimide resin solution. In the resin included in the filler-dispersed polyimide resin solution, the amount of the polyimide resin having a dicarboxylic anhydride at both ends (the polyimide resin A) was 100% by mass.

### [Inventive Examples 2 to 4]

Filler-dispersed polyimide resin solutions were prepared in the same manner as in Inventive Example 1, except that the added amount of the aluminum oxide powder was set to the amount described in Table 1 below.

### [Inventive Example 5]

A filler-dispersed polyimide resin solution was prepared in the same manner as in Inventive Example 1, except that 4 g of the polyimide resin A and 2 g of the polyimide resin B were added to 10 g of DMF and the added amount of the aluminum oxide powder was set to the amount described in Table 1 below. In the resin included in the filler-dispersed polyimide resin solution, the amount of the polyimide resin having dicarboxylic anhydride at both ends (the polyimide resin A) was 66.7% and the amount of the polyimide resin having an amine group at both ends (the polyimide resin B) was 33.3% by mass.

### [Inventive Example 6]

A filler-dispersed polyimide resin solution was prepared in the same manner as in Inventive Example 1, except that cyclohexanone was used instead of DMF, 1 g of the polyimide resin C instead of the polyimide resin A was added to 10 g of cyclohexanone and the added amount of aluminum oxide powder was the amount described in Table 1 below. In the resin included in the filler-dispersed polyimide resin solution, the amount of the polyimide resin having dicarboxylic anhydride at both ends (the polyimide resin C) was 100% by mass.

### [Inventive Example 7]

A filler-dispersed polyimide resin solution was prepared in the same manner as in Inventive Example 1, except that magnesium oxide powder (average particle diameter: 10 µm) was added instead of aluminum oxide powder in the amount described in Table 1 below.

### [Inventive Example 8]

A filler-dispersed polyimide resin solution was prepared in the same manner as in Inventive Example 1, except that aluminum hydroxide powder (average particle diameter: 3 µm) was added instead of aluminum oxide powder in the amount described in Table 1 below.

### [Inventive Example 9]

4.85 g of the polyimide resin A was added to 10 g of DMF and stirred until uniformly dissolved. 0.15 g of epoxy resin raw material (JER-630, manufactured by Mitsubishi Chemical Corporation) was added to the obtained polyimide resin solution. Furthermore, aluminum oxide powder (average particle diameter: 3 µm) was added so that the added amount became 79% by mass in terms of mass (57% by volume in terms of volume) with respect to the total amount of the polyimide resin A, epoxy resin, and aluminum oxide powder, and the mixture was stirred with a magnetic stirrer. The obtained mixture was subjected to a dispersion treatment by repeating a high-pressure ejection treatment ten times at a pressure of 50 MPa using a Starburst manufactured by Sugino Machine Ltd., to prepare a filler-dispersed polyimide resin solution. In the resin included in the filler-dispersed polyimide resin solution, the amount of the polyimide resin having dicarboxylic anhydride at both ends (the polyimide resin A) was 97% by mass and the amount of the epoxy resin was 3% by mass.

### [Inventive Example 10]

A filler-dispersed polyimide resin solution was prepared in the same manner as in Inventive Example 1, except that aluminum oxide powder having an average particle diameter of 0.7 µm was added instead of aluminum oxide powder having an average particle diameter of 3 µm in the amount described in Table 1 below.

### [Comparative Example 1]

A filler-dispersed polyimide resin solution was prepared in the same manner as in Inventive Example 1, except that 5 g of the polyimide resin B instead of the polyimide resin A was added to 10 g of DMF and the added amount of aluminum oxide powder was set to the amount described in Table 1 below.

### [Comparative Example 2]

A filler-dispersed polyimide resin solution was prepared in the same manner as in Inventive Example 1, except that silica powder (average particle diameter: 0.7 µm) was added instead of aluminum oxide powder in the amount described in Table 1 below.

### [Comparative Example 3]

A filler-dispersed polyimide resin solution was prepared in the same manner as in Inventive Example 1, except that 1 g of the polyimide resin D instead of the polyimide resin A was added to 10 g of DMF and the added amount of aluminum oxide powder was the amount described in Table 1 below.

### [Evaluation]

Using each of the filler-dispersed polyimide resin solutions obtained in Inventive Examples 1 to 10 and Comparative Examples 1 to 3, a polyimide resin composition film including a filler was prepared and the filler dispersibility, void occupancy rate, thermal conductivity, and withstand voltage per film thickness of the obtained polyimide resin film were evaluated by the following methods. The results are shown in Table 1 below.

### (Filler Dispersibility)

A filler-dispersed polyimide resin solution was spin-coated at a rotational speed of 500 rpm onto a copper substrate having a dimension of 50 mm long × 50 mm wide × 1 mm thick to obtain a coated film having a thickness of 20 µm. By heating and drying the obtained coated film at a temperature of 100°C for 3 hours, a polyimide resin composition film including a filler was formed to obtain a copper substrate with an attached polyimide resin composition film. The obtained polyimide resin composition film was observed using an optical microscope to measure the number of aggregates of filler having a particle diameter of 0.1 mm or more. A case where the number of aggregates per 1 cm² of the polyimide resin composition film was 3 or less was classified as A, a case where the number of aggregates was 4 or more and 10 or less was classified as B, and a case where the number of aggregates was 11 or more was classified as C.

### (Void Occupancy Rate)

A filler-dispersed polyimide resin solution was coated on a PTFE (polytetrafluoroethylene) sheet having a dimension of 50 mm long × 50 mm wide × 1 mm thick using a bar coater to obtain a coated film having a thickness of 100 µm. The obtained coated film was heated at a temperature of 100°C for 30 minutes, then heated at a temperature of 150°C for 30 minutes and dried to form a polyimide resin composition film including a filler. The obtained polyimide resin composition film was peeled off from the PTFE sheet and filled in with resin.

The cross-section of the polyimide resin composition film filled in resin was exposed by CP processing. Next, the exposed cross-section of the polyimide resin composition film was observed using a scanning electron microscope (SEM). The area occupied by voids was measured with respect to a cross sectional area of 100 µm² of the polyimide resin composition film and the occupancy rate was calculated.

In the cross-section which was the SEM observation object, the regions present between the polyimide resin and the filler, which were neither polyimide nor filler, were the voids. The minimum area of voids was set to 0.01 µm².

### (Thermal Conductivity)

A filler-dispersed polyimide resin solution was coated on a copper substrate having a dimension of 50 mm long × 50 mm wide × 1 mm thick using a bar coater to obtain a coated film having a thickness of 100 µm. By heating and drying the obtained coated film at a temperature of 100°C for 3 hours, a polyimide resin composition film including a filler was formed to obtain a copper substrate with an attached polyimide resin composition film.

The thermal conductivity of the polyimide resin composition film (thermal conductivity in the thickness direction of the polyimide resin composition film) was measured by the laser flash method using the LFA477 Nanoflash manufactured by NETZSCH-Gerätebau GmbH.

### (Withstand Voltage Per Film Thickness)

The withstand voltage of the polyimide resin composition film was measured using a 7440 multifunctional safety tester manufactured by Keisoku Giken Co., Ltd.

A copper substrate with an attached polyimide resin composition film was obtained in the same manner as in the measurement of the thermal conductivity described above. An electrode (ϕ 6 mm) was arranged on the surface of the polyimide resin composition film of the copper substrate with an attached polyimide resin composition film. The copper substrate of the copper substrate with the attached polyimide resin composition film and the electrode arranged on the surface of the polyimide resin composition film were respectively connected to the power supply and boosted to 6000 V in 30 seconds. The voltage at the time point at which the current value flowing between the copper substrate and the electrode reached 5000 µA was used as the withstand voltage of the polyimide resin composition film. The film thickness was measured with a micrometer and the withstand voltage per film thickness was calculated by dividing the withstand voltage by the film thickness.

**[Table 1]**

| | Polyimide | | Filler | | | | Evaluation | | | |
|---|---|---|---|---|---|---|---|---|---|---|
| | Type | Amount (% by mass) | Type | Average particle diameter (µm) | Amount (% by mass) | Amount (% by volume) | Filler dispersibility | Void occupancy rate (%) | Thermal conductivity (W/m·k) | Withstand voltage (kV/mm) |
| Inventive Example 1 | Polyimide resin A | 40 | Aluminum oxide | 3 | 60 | 35 | A | 0 | 0.8 | 240 |
| Inventive Example 2 | Polyimide resin A | 28 | Aluminum oxide | 3 | 72 | 48 | A | 1 | 1.2 | 180 |
| Inventive Example 3 | Polyimide resin A | 21 | Aluminum oxide | 3 | 79 | 57 | A | 2 | 2.1 | 140 |
| Inventive Example 4 | Polyimide resin A | 16 | Aluminum oxide | 3 | 84 | 65 | A | 5 | 2.5 | 110 |
| Inventive Example 5 | Polyimide resin A Polyimide resin B | 21 | Aluminum oxide | 3 | 79 | 57 | A | 2 | 2.0 | 140 |
| Inventive Example 6 | Polyimide resin C | 21 | Aluminum oxide | 3 | 79 | 57 | A | 4 | 1.8 | 130 |
| Inventive Example 7 | Polyimide resin A | 22 | Magnesium oxide | 10 | 78 | 58 | A | 2 | 2.2 | 130 |
| Inventive Example 8 | Polyimide resin A | 32 | Aluminum hydroxide | 3 | 68 | 56 | A | 1 | 2.0 | 150 |
| Inventive Example 9 | Polyimide resin A Epoxy resin | 21 | Aluminum oxide | 3 | 79 | 57 | A | 2 | 1.9 | 150 |
| Inventive Example 10 | Polyimide resin A | 22 | Aluminum oxide | 0.7 | 79 | 57 | A | 2 | 1.8 | 160 |
| Comparative Example 1 | Polyimide resin B | 21 | Aluminum oxide | 3 | 79 | 57 | C | Aggregates were formed and thus measurement was not possible | | |
| Comparative Example 2 | Polyimide resin A | 28 | Silica | 0.7 | 72 | 58 | C | Aggregates were formed and thus measurement was not possible | | |
| Comparative Example 3 | Polyimide resin D | 21 | Aluminum oxide | 3 | 79 | 57 | C | Aggregates were formed and thus measurement was not possible | | |

With regard to the polyimide resin composition films formed using the filler-dispersed polyimide resin solutions of Inventive Examples 1 to 10 in which a polyimide resin having a dicarboxylic acid group or anhydride group thereof at both ends was used and any one of aluminum oxide powder, aluminum hydroxide powder, magnesium oxide powder, or magnesium hydroxide powder was included as the filler, the filler dispersibility was excellent, the void occupancy rate was low, and the thermal conductivity and the withstand voltage were high. This is because the dicarboxylic acid groups or anhydride groups thereof at both ends of the polyimide resin and the filler have a high affinity and defects are not easily generated between the polyimide resin and the filler. For example, in a case where the filler is aluminum oxide powder, the dicarboxylic anhydride groups at the ends of the polyimide resin are easily hydrolyzed by adsorbed water on the aluminum oxide particles or moisture in the air to form dicarboxylic acid groups. The dicarboxylic acid groups react with the hydroxyl groups on the aluminum oxide particles to form two carboxylate groups. The two formed carboxylate groups are stabilized by bidentate cross-linking to each of two aluminum atoms and the polyimide resin is fixed on the surface of the aluminum oxide particles. Heating at a temperature of 100°C or higher is preferable for the reaction progress of the bidentate cross-linking.

In contrast, with regard to Comparative Examples 1 and 3 in which polyimide resin not having dicarboxylic acid groups and anhydride groups thereof at both ends was used, and Comparative Example 2 in which silica powder was used as filler, the filler dispersibility in the polyimide resin composition film decreased. In the polyimide resin composition films obtained in Comparative Examples 1 and 3 and Comparative Example 2, many aggregates were formed and thus it was not possible to measure the void occupancy rate, thermal conductivity, and withstand voltage.

### [Industrial Applicability]

It is possible to provide a resin composition including a filler and a resin, which is less likely to generate voids and has excellent thermal conductivity and voltage resistance, and a metal base substrate using this resin composition as an insulating film.

### [Reference Signs List]

10: Polyimide resin composition
11: Polyimide resin
12: Filler
20: Metal Base Substrate
21: Metal Substrate
22: Insulating film
23: Metal circuit layer

## Claims

1. A polyimide resin composition comprising:
a resin; and
a filler dispersed in the resin,
wherein the resin includes a polyimide resin having a dicarboxylic acid group or an acid anhydride group of the dicarboxylic acid group at both ends, and
the filler includes at least one inorganic compound selected from the group consisting of aluminum oxide, aluminum hydroxide, magnesium oxide, and magnesium hydroxide on a surface thereof.

2. The polyimide resin composition according to Claim 1,
wherein the polyimide resin is a compound represented by General Formula (1) or General Formula (2), 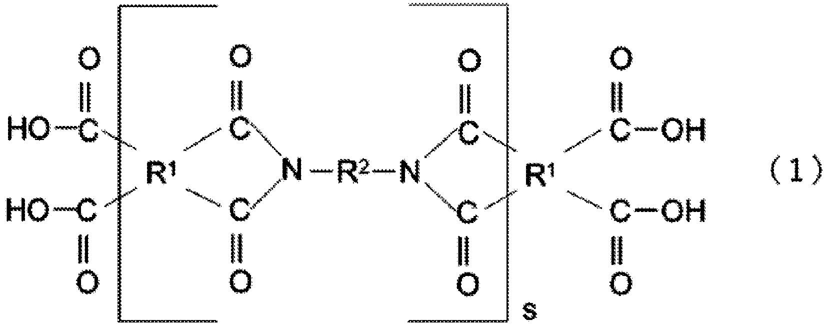 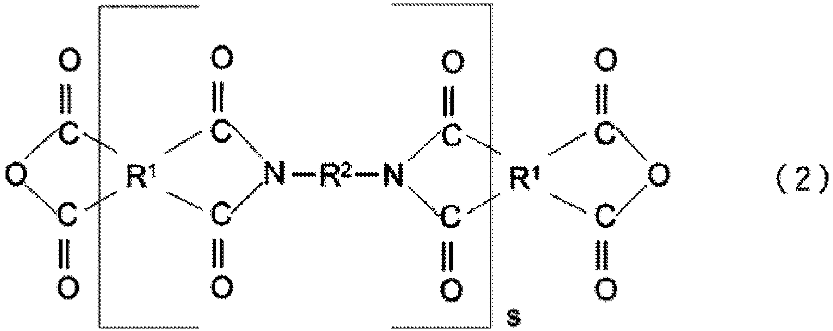 in General Formula (1) and General Formula (2), R1 represents a tetravalent organic group, R2 represents a divalent organic group, and S represents a number of 10 or more and 200 or less calculated from a number average molecular weight.

3. The polyimide resin composition according to Claim 1 or 2,
wherein a number average molecular weight of the polyimide resin is in a range of 5000 or more and 50000 or less.

4. The polyimide resin composition according to any one of Claims 1 to 3,
wherein an amount of the filler is in a range of 60% by mass or more and 90% by mass or less.

5. The polyimide resin composition according to any one of Claims 1 to 4,
wherein an amount of the polyimide resin in the resin is in a range of 66% by mass or more and 100% by mass or less.

6. A metal base substrate comprising:
a metal substrate;
an insulating film; and
a metal circuit layer, which are laminated in this order,
wherein the insulating film consists of the polyimide resin composition according to any one of Claims 1 to 5.
